(19) **Europäisches Patentamt**
**European Patent Office**
**Office européen des brevets**

(11) **EP 3 863 075 B1**

(12) **FASCICULE DE BREVET EUROPEEN**

(45) Date de publication et mention
de la délivrance du brevet:
**15.01.2025 Bulletin 2025/03**

(21) Numéro de dépôt: **21155570.1**

(22) Date de dépôt: **05.02.2021**

(51) Classification Internationale des Brevets (IPC):
***H10N 70/20*** *(2023.01)*

(52) Classification Coopérative des Brevets (CPC):
**H10B 63/10; H10B 63/20; H10N 70/026;**
**H10N 70/231; H10N 70/826; H10N 70/8825**

(54) **ELÉMENT DE SÉLECTION ET PROCÉDÉ DE FABRICATION CORRESPONDANT**

AUSWAHLELEMENT UND ENTSPRECHENDES HERSTELLUNGSVERFAHREN

SELECTION ELEMENT AND CORRESPONDING FABRICATION METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.02.2020 FR 2001228**

(43) Date de publication de la demande:
**11.08.2021 Bulletin 2021/32**

(73) Titulaire: **Commissariat à l'Energie Atomique et
aux Energies
Alternatives
75015 Paris (FR)**

(72) Inventeurs:
• **NAVARRO, Gabriele
38054 GRENOBLE CEDEX 09 (FR)**

• **BERNARD, Mathieu
38054 GRENOBLE CEDEX 09 (FR)**
• **SABBIONE, Chiara
38054 GRENOBLE CEDEX 09 (FR)**
• **CYRILLE, Marie-Claire
38054 GRENOBLE CEDEX 09 (FR)**
• **LAGUNA, Camille
38054 GRENOBLE CEDEX 09 (FR)**

(74) Mandataire: **Cabinet Beaumont
4, Place Robert Schuman
B.P. 1529
38025 Grenoble Cedex 1 (FR)**

(56) Documents cités:
**US-A1- 2003 133 339     US-A1- 2012 305 876
US-A1- 2019 115 393**

## Description

<u>Domaine technique</u>

La présente invention concerne de façon générale les éléments de sélection d'une mémoire et plus particulièrement les éléments de sélection à base de matériaux à changement de phase.

<u>Technique antérieure</u>

Les matériaux à changement de phase sont des matériaux à base de matériaux chalcogénures dont la résistance peut varier lors de l'échauffement de ce matériau, par exemple sous l'effet d'impulsions électriques spécifiques appliquées entre deux électrodes. Une transition se fait entre une phase cristalline, ordonnée, de faible résistance et thermodynamiquement stable, et une phase amorphe, désordonnée, de résistance élevée et thermodynamiquement instable. Comme la résistance électrique d'un matériau amorphe est significativement supérieure à la résistance électrique d'un matériau cristallin, ce phénomène est souvent utilisé dans les mémoires à changement de phase pour définir deux états de mémoire, par exemple 0 et 1, différenciés par la résistance mesurée à travers le matériau à changement de phase. D'autres composants peuvent cependant être fabriqués à l'aide de matériaux à changement de phase, par exemple des éléments de sélection, aussi appelés interrupteurs à seuil ovonic ou OTS (Ovonic Threshold Switch).

Les alliages utilisés pour former ces composants sont souvent en proportions stoechiométriques. Des alliages ayant des proportions non stoechiométriques peuvent cependant être préférés à des alliages ayant des proportions stoechiométriques car ils peuvent avoir des caractéristiques souhaitées, par exemple une température de cristallisation plus élevée. Cependant, la fabrication d'éléments de sélection comprenant de tels alliages présente divers inconvénients. Notamment, la séparation de phase et/ou la potentielle cristallisation de tels alliages peut entraîner une dégradation de la fonctionnalité de l'élément de sélection.

Un exemple de l'art antérieur se trouve dans US2019/115393.

Résumé de l'invention

Un mode de réalisation pallie tout ou partie des inconvénients des éléments de sélection connus.

Un mode de réalisation prévoit un élément de sélection comprenant, dans une première portion, un empilement de couches amorphes, l'épaisseur de chaque couche de l'empilement étant inférieure ou égale à 20 nm.

Au moins une des couches de l'empilement comprend un élément du groupe 16, et l'élément comprend une deuxième portion traversant au moins certaines couches de l'empilement, en un alliage d'au moins une partie des composants des couches de l'empilement.

Selon un mode de réalisation, l'empilement comprend au moins un ensemble de premières couches et un ensemble de deuxièmes couches, les premières et deuxièmes couches étant en des matériaux différents.

Selon un mode de réalisation, les premières couches sont en un alliage comprenant un élément du groupe 15 et un élément du groupe 16, et dans lequel les deuxièmes couches sont en :

- un élément du groupe 14 seul ou dopé, par exemple dopé avec de l'azote, de l'oxygène ou du carbone ; ou
- un alliage comprenant un élément du groupe 14 et un élément du groupe 16.

Selon un mode de réalisation, l'empilement comprend une alternance de premières et de deuxièmes couches.

Selon un mode de réalisation, les premières couches sont en un alliage à base de germanium dopé avec de l'azote, et les deuxièmes couches sont en un alliage d'antimoine et de sélénium.

Selon un mode de réalisation, le matériau de chaque couche de l'empilement a des proportions stoechiométriques.

Selon un mode de réalisation, l'élément comprend une électrode en contact avec la deuxième portion.

Selon un mode de réalisation, des couches d'un ensemble de couches de l'empilement sont dopées.

Selon un mode de réalisation, les couches de l'ensemble de couches sont dopées avec un ou plusieurs dopants parmi l'azote, le carbone et le silicium.

Un autre mode de réalisation prévoit un dispositif mémoire comprenant un élément de mémorisation disposé électriquement en série avec un élément de sélection défini précédemment.

Un autre mode de réalisation prévoit un procédé de fabrication d'un élément de sélection comprenant la formation d'un empilement de couches amorphes, l'épaisseur de chaque couche étant inférieure ou égale à 20 nm.

Selon un mode de réalisation, le procédé comprend une étape au cours de laquelle une impulsion de courant est envoyée à travers l'empilement de couches, de manière à former une portion comprenant un alliage d'au moins une partie des composants des couches de l'empilement.

Selon un mode de réalisation, le procédé comprend une étape de fabrication d'une électrode inférieure et la fabrication d'une électrode supérieure.

Selon un mode de réalisation, les proportions du matériau de la deuxième portion ne sont pas stoechiométriques.

Selon un mode de réalisation, les première et deuxième portions sont séparées par une peau en un matériau d'une des couches de l'empilement.

Selon un mode de réalisation, le matériau de la deuxième portion est un matériau à changement de phase.

Selon un mode de réalisation, le dopage des couches de l'ensemble de couches est graduel.

Brève description des dessins

Ces caractéristiques et avantages, ainsi que d'autres, seront exposés en détail dans la description suivante, des modes de réalisation particuliers faite à titre non limitatif et en relation avec les figures parmi lesquelles :

la figure 1 est une vue en coupe schématique et partielle d'un mode de réalisation d'un élément de sélection ;

la figure 2 est une vue en coupe schématique et partielle d'un mode de réalisation d'une cellule mémoire ;

la figure 3 illustre le fonctionnement de l'élément de sélection de la figure 1 ;

la figure 4 est un graphique représentant les liaisons entres composants présentes à différents états de plusieurs exemples de modes de réalisation d'élément de sélection ;

la figure 5 illustre des exemples de comparaisons de nombres de liaisons de la figure 4 ;

la figure 6 représente schématiquement et partiellement une structure obtenue à l'issue d'une étape de la fabrication de l'élément de mémorisation de la figure 2 ;

la figure 7 représente schématiquement et partiellement une structure obtenue à l'issue d'une autre étape de fabrication de la cellule mémoire de la figure 2 ;

la figure 8 représente des variations de tensions au cours de la vie de plusieurs modes de réalisation d'élément de sélection ;

la figure 9 est une vue en coupe schématique et partielle d'un autre mode de réalisation d'un élément de sélection à l'issue d'une étape de fabrication ; et

la figure 10 représente un autre mode de réalisation d'un élément de sélection.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

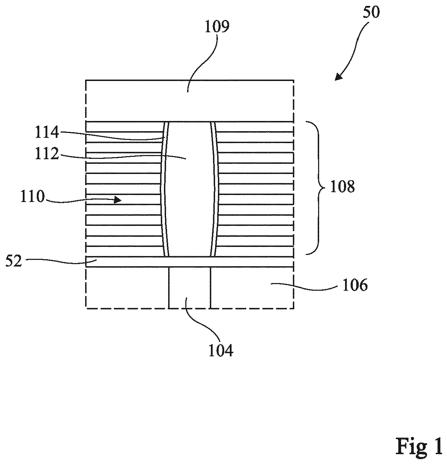

La figure 1 est une vue en coupe schématique et partielle d'un mode de réalisation d'un élément de sélection 50.

L'élément de sélection 50 comprend une première électrode 52, ou électrode inférieure. Dans l'exemple de la figure 1, l'électrode 52 est une couche conductrice. L'électrode 52 est, dans cet exemple, en contact avec un via conducteur 104. Le via 104 permet de relier l'électrode à un noeud d'application d'un potentiel. Le via conducteur 104 est entouré d'une couche isolante 106. L'épaisseur de la couche 106 est telle que la face, ou extrémité, supérieure du via 104 est coplanaire avec la face supérieure de la couche isolante 106. La couche conductrice constituant l'électrode 52 repose sur la face supérieure du via et sr la face supérieure de la couche isolante 106.

L'élément de sélection 50 comprend une région 108. La région 108 comprend une première portion 110. Après une étape d'initialisation, ou de "firing", qui sera décrite plus en détail par la suite, la région 108 comprend en outre une deuxième portion 112. Avant l'étape de "firing" effectuée, par exemple avant la première utilisation de l'élément, la région 108 ne comprend que la première portion 110.

La première portion 110 comprend un empilement de couches, de préférence toutes en matériaux amorphes. La région 108 est située sur l'électrode 52. Ainsi, la couche inférieure de l'empilement 110 recouvre l'électrode 52. Les couches de l'empilement sont de préférence en des éléments chimiques, ou des alliages d'éléments chimiques, des groupes 14, 15 ou 16 du tableau périodique des éléments, selon la classification de l'union internationale de chimie pure et appliquée (UICPA).

Le groupe 14 comprend le carbone (C), le silicium (Si), le germanium (Ge), l'étain (Sn), le plomb (Pb), et le flérovium (Fl). Le groupe 15 comprend l'azote (N), le phosphore (P), l'arsénique (As), l'antimoine (Sb), le bismuth (Bi), et le moscovium (Mc). Le groupe 16 comprend l'oxygène (O), le souffre (S), le sélénium (Se), le tellure (Te), le polonium (Po) et le livermorium (Lv).

Chaque couche de l'empilement 110 est en un matériau ayant de préférence des proportions stoechiométriques ou sensiblement stoechiométriques. De préférence, au moins certaines couches de l'empilement 110, de préférence toutes les couches de l'empilement 110, comprennent :

- un alliage comprenant un élément du groupe 15 et un élément du groupe 16 ; ou
- un élément du groupe 14 seul ou dopé, par exemple dopé avec de l'azote, de l'oxygène ou du carbone ; ou
- un alliage comprenant un élément du groupe 14 et un élément du groupe 16.

De préférence, au moins une des couches de l'empilement 110 comprend un élément parmi le sélénium, le tellure et le soufre. Les alliages des couches de l'empilement 110 sont par exemple des matériaux choisis dans la liste suivante : $GeSe_2$, GeSe, $As_2Te_3$, $Sb_2Se_3$, $As_2Se_3$, Ge dopé N ou non dopé, $GeS_2$, GeS, $Sb_2S_3$, $As_2S3$. Les alliages des couches de l'empilement 110 peuvent par exemple être dopées, par exemple avec de l'azote, de l'oxygène ou du carbone.

L'empilement 110 comprend par exemple une alternance de premières et de deuxièmes couches, les premières et deuxièmes couches étant en des matériaux différents. De préférence, l'empilement comprend uniquement les premières et deuxièmes couches. De préférence, les premières couches sont par exemple en un alliage comprenant un élément du groupe 15 et un élément du groupe 16. Les deuxièmes couches sont de préférence en un alliage comprenant un élément du groupe 14 et un élément du groupe 16 ou en un élément du groupe 14 seul ou dopé, par exemple dopé avec de l'azote, de l'oxygène ou du carbone.

Les premières couches sont, de préférence, en un alliage à base d'antimoine et de sélénium (SbSe), et les deuxièmes couches sont de préférence en un matériau à base de germanium et d'azote, par exemple en germanium dopé avec de l'azote (GeN). Par exemple, les deuxièmes couches sont en un matériau n'étant pas un matériau à changement de phase.

Chacune des couches de l'empilement 110 a une épaisseur inférieure ou égale à environ 20 nm, par exemple inférieure ou égale à 5 nm. Par exemple, chaque couche de l'empilement a une épaisseur supérieure à 1 nm.

Par exemple, les épaisseurs des premières couches, notées A, et des deuxièmes couches, notées B, peuvent être déterminées dans la gamme précédemment évoquée en résolvant les équations suivantes :

[Math 1]

$$T = (N_A * t_A + N_B * t_B)$$

[Math 2]

$$P_A = 100 \times \frac{N_A * t_A}{N_A * t_A + N_B * t_B}$$

[Math 3]

$$P_B = 100 \times \frac{N_B * t_B}{N_A * t_A + N_B * t_B}$$

où T est l'épaisseur totale de l'empilement 110, $t_A$ est l'épaisseur d'une couche A, $t_B$ est l'épaisseur d'une couche B, $N_A$ est le nombre de couches A, $N_B$ est le nombre de couches B (par exemple égal au nombre de couches A), $P_A$ est la proportion volumique (en ô) du matériau des couches A dans l'ensemble de l'empilement, $P_B$ est la proportion volumique (en %) du matériau des couches B dans l'ensemble de l'empilement.

De manière plus générale, l'empilement comprend au moins deux ensembles de couches, chaque ensemble comprenant des couches en un matériau différent des matériaux des couches des autres ensembles. De préférence, toutes les couches d'un même ensemble sont en un même matériau. Les couches d'un même ensemble peuvent avoir des niveaux de dopages différents. De préférence, toutes les couches d'un même ensemble sont dopés avec les mêmes dopants. Cependant, selon un mode de réalisation, certaines couches d'un même ensemble peuvent par exemple être dopées avec des dopants différents.

Les première et deuxième portions 110 et 112 peuvent être séparées par une peau 114 en un des éléments chimiques de l'empilement 110. De préférence, la peau 114 est en un seul matériau. La peau s'étend sur la hauteur d'au moins deux couches de l'empilement 110. La peau 114 est par exemple entièrement en un alliage constituant l'une des couches. La peau 114 est par exemple entièrement en un élément chimique d'un des alliages constituant l'une des couches de l'empilement. Par exemple, si l'empilement 110 comprend des couches de GeN et SbSe, la peau 114 peut être en germanium.

La deuxième portion 112, résultant de la fusion de couches de l'empilement 110 comme cela sera décrit par la suite, est en contact avec la face supérieure de la couche 106 et la face supérieure de l'électrode 52.

Dans l'exemple de la figure 1, la deuxième portion s'étend sur toute la hauteur de l'empilement. De manière plus générale, la deuxième portion traverse au moins certaines couches de l'empilement 110. De préférence, la deuxième portion traverse au moins deux couches de l'empilement.

La deuxième portion 112 est en un alliage d'éléments chimiques, des couches de l'empilement 110. De préférence, le matériau formant la deuxième portion comprend tous les éléments chimiques constituant les couches de l'empilement. La deuxième portion 112 est en un matériau à changement de phase. De préférence, la deuxième portion est par exemple en un matériau amorphe lors de son utilisation. La deuxième portion 112 est par exemple en un matériau ayant des proportions non stoechiométriques. La deuxième portion 112 est par exemple en un alliage de germanium, de sélénium, d'antimoine et d'azote (GeSeSbN).

Une couche conductrice 109 repose sur la région 108. La couche conductrice 109 forme une deuxième électrode de l'élément de sélection, ou électrode supérieure. De préférence, la deuxième portion s'étend d'une électrode à l'autre.

Lors du fonctionnement de l'élément de sélection, une tension est appliquée entre les électrodes 52 et 109. Si la tension appliquée est supérieure à une tension de seuil, l'élément de sélection se comporte similairement à un interrupteur fermé.

Des expériences ont montré que, d'un point de vue macroscopique, c'est-à-dire en considérant l'empilement entier comme étant un unique élément, l'empilement de couches a un comportement électrique similaire à un bloc massif en un alliage comprenant tous les éléments chimiques des couches de l'empilement.

Cependant, les composants d'un bloc massif d'un alliage n'ayant pas de proportions stoechiométriques ont tendance à se recomposer en éléments stoechiométriques particulièrement lorsqu'ils sont soumis aux températures relativement élevées des procédés de fabrication. Il s'agit du phénomène de séparation de phases et de la potentielle cristallisation consécutive de ces phases. Cette recomposition entraine une variabilité entre des éléments de sélection autrement sensiblement identiques. Les modes de réalisation décrits, comprenant déjà des couches ayant des proportions stoechiométriques, sont moins sujettes à de telles recompositions.

Des résultats similaires sont observés pour des empilements comprenant des couches de matériaux précédemment évoqués.

De tels résultats ne peuvent être observés pour des empilements de couches ayant des épaisseurs supérieures à 20 nm. En effet, au niveau des interfaces entre deux couches, les éléments chimiques des deux couches forment des connexions, éventuellement des alliages, de la même manière que si les différents éléments chimiques étaient réunis dans un bloc massif. Les épaisseurs considérées des couches des empilements des modes de réalisation décrits permettent qu'une partie suffisante de chaque couche soit sujette à ce phénomène pour que, d'un point de vue macroscopique, l'empilement se comporte sensiblement comme un bloc massif.

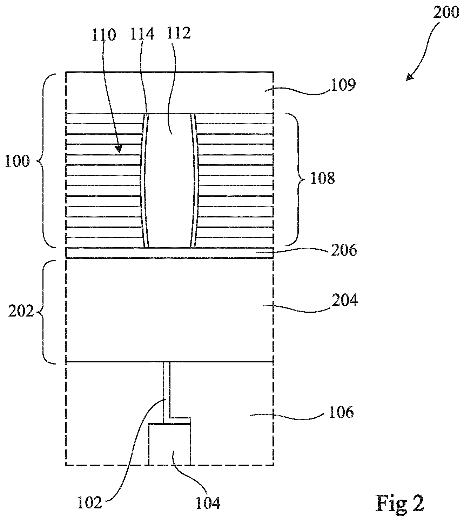

La figure 2 représente un mode de réalisation d'une cellule mémoire 200 comprenant un élément de sélection 100. La cellule mémoire 200 comprend, de plus, un élément de mémorisation 202. Dans l'exemple de la figure 2, l'élément de mémorisation est un élément de mémorisation à changement de phase. L'élément de mémorisation 202 comprend donc une couche, ou un empilement de couches, 204, en un matériau à changement de phase.

La cellule mémoire 200 comprend une première électrode 102, ou électrode inférieure. Dans l'exemple de la figure 2, l'électrode 102 est située sur le via conducteur 104. L'électrode 102 est par exemple un élément résistif. L'électrode 102 a par exemple une section en forme de L dont la partie horizontale est en contact avec le via conducteur 104. L'électrode 102 et le via conducteur 104 sont entourés de la couche isolante 106. L'épaisseur de la couche 106 est telle que la face ou extrémité supérieure de la partie verticale de l'électrode 102 est coplanaire avec la face supérieure de la couche isolante 106.

L'élément de mémorisation 202 repose sur la face supérieure de la couche isolante 106 et sur la face supérieure de la partie verticale de l'électrode 102. L'électrode 102 peut ainsi faire chauffer le matériau de l'élément de mémorisation de manière à le faire changer de phase, et donc à programmer la cellule mémoire.

L'élément de sélection 100 est de préférence situé sur l'élément de mémorisation 202. Alternativement, la position de l'élément de mémorisation et la position de l'élément de sélection peuvent être inversés. Ainsi, l'élément de sélection peut être situé en contact avec l'électrode 102 et être recouvert par l'élément de mémorisation.

L'élément de sélection 100 comprend, comme l'élément de sélection 50 de la figure 1, la région 108. La région 108 comprend, comme précédemment, la portion 110, la portion 112 et la peau 114.

L'élément de sélection 100 est, par exemple, séparé de l'élément de mémorisation 202 par une couche d'interface 206. La couche d'interface est de préférence une couche conductrice, par exemple une couche métallique. La couche d'interface 206 est par exemple une électrode reliée à un noeud d'application d'une tension. La couche d'interface recouvre par exemple la face supérieure de l'élément de mémorisation et est par exemple recouverte par l'élément de sélection. La couche d'interface permet de s'assurer que les changements faits dans la composition de l'élément de mémorisation ou de l'élément de sélection n'aient pas d'impact sur l'autre élément. Par exemple, la couche d'interface permet de s'assurer que la cristallisation de l'élément de mémorisation n'entraine pas, même partiellement, la cristallisation de l'élément de sélection.

Lors du fonctionnement de la cellule mémoire, une tension est appliquée entre les électrodes 102 et 109. Si la tension appliquée est supérieure à une tension de seuil, l'élément de sélection se comporte similairement à un interrupteur fermé. Un courant peut donc traverser l'élément de mémorisation et l'élément de sélection, de manière à programmer ou lire la cellule mémoire.

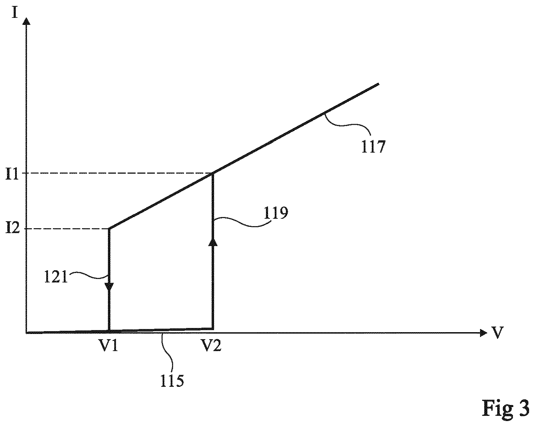

La figure 3 illustre le fonctionnement de l'élément de sélection 50 de la figure 1, le fonctionnement de l'élément de sélection 100 de la figure 2 étant identique. La figure 3 représente la caractéristique de l'élément de sélection 50, c'est à dire le courant I traversant l'élément de sélection en fonction de la tension V aux bornes de l'élément de sélection, c'est-à-dire entre les électrodes 52 et 109.

L'élément de sélection prend un premier état dans lequel le courant I traversant l'élément de sélection est faible et par exemple sensiblement constant. Le courant dans le premier état est par exemple sensiblement égal à 0. La résistivité de l'empilement est élevée, de même que celle de la deuxième portion, interdisant alors le courant de circuler d'une électrode à l'autre, par exemple vers un composant relié en série avec l'élément de sélection, par exemple une mémoire. Cet état est représenté par la portion de courbe 115. Ce premier état est associé à des valeurs de tension V basses, c'est-à-dire inférieure à une valeur de tension V2.

Lorsque l'élément de sélection est dans le premier état et que la tension V atteint de la valeur V2, l'élément de sélection entre dans un deuxième état, représenté par une portion de courbe 117, après un court passage dans un premier état intermédiaire représenté par une portion de courbe 119. Le premier état intermédiaire correspond à un saut de courant, c'est-à-dire que le gradient de la portion de courbe 119 est élevé.

Lorsque l'élément de sélection entre dans le deuxième état, le courant I est égal à une valeur I1 de courant. De plus, le courant I est par exemple une fonction linéaire de la valeur de la tension V. Ainsi, dans le deuxième état, le courant augmente lorsque la tension augmente. Dans cet état, la résistivité de la deuxième portion 112 est réduite, permettant alors au courant de circuler d'une électrode à l'autre, par exemple vers un composant relié en série avec l'élément de sélection, par exemple une mémoire.

Pour sortir du deuxième état et revenir dans le premier état, la tension est diminuée jusqu'à atteindre une valeur V1 de la tension, par exemple inférieure à la tension V2, correspondant à une valeur I2 du courant. Lorsque la tension V1 est atteinte, l'élément de sélection entre dans un deuxième état intermédiaire représenté par une portion de courbe 121 et ensuite retourne dans le premier état. Le deuxième état intermédiaire correspond à un autre saut de courant, c'est-à-dire que le gradient de la portion de courbe 121 est élevé.

Le comportement de l'élément de sélection est similaire au comportement d'un interrupteur. En effet, l'élément de sélection comprend deux états principaux, un premier état (interrupteur ouvert) dans lequel aucun courant ne circule à travers l'élément de sélection ou dans lequel seul un faible courant de bruit traverse l'élément de sélection, et un deuxième état (interrupteur fermé) dans lequel un courant circule.

De préférence, la région 108 n'est pas soumise, durant son fonctionnement en tant qu'élément de sélection, à des tensions suffisamment élevées pour entraîner la cristallisation de la région. Ainsi, dans le deuxième état, la deuxième portion est de préférence dans un état au moins partiellement amorphe, de préférence entièrement amorphe.

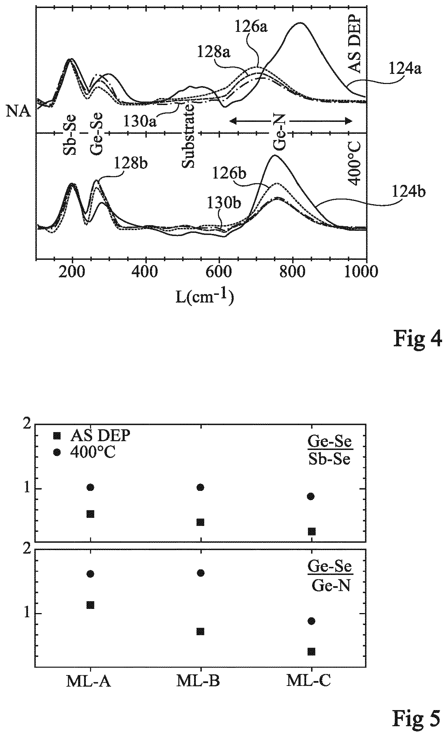

La figure 4 est un graphique représentant les liaisons présentes entre composants dans des éléments de sélection tels que celui de la figure 1. Plus précisément, la figure 3 représente le spectre d'absorption (NA) en fonction de la longueur d'onde (L(cm$^{-1}$)) pour plusieurs éléments de sélection lors du dépôt (AS DEP) des couches de l'élément de sélection et après une chauffe des éléments de sélection à 400 °C.

Le spectre d'absorption correspond au spectre obtenu (en cm$^{-1}$) par spectroscopie infrarouge à transformée de Fourier. Plus la valeur de l'absorbance à une longueur d'onde donnée est élevée, plus le nombre de liaisons correspondant à cette longueur d'onde est important.

Des courbes 124a et 124b correspondent à un élément de sélection dans lequel les première et deuxième portions 110 et 112 sont remplacées par un bloc massif ("bulk") du matériau formant la deuxième portion 112, respectivement lors du dépôt (AS DEP) des couches de l'empilement 110 et pour la chauffe de l'élément de sélection à 400 °C.

Des courbes 126a et 126b correspondent, respectivement lors du dépôt (AS DEP) des couches de l'empilement 110 et lors de la chauffe des éléments de sélection à 400 °C, à un élément de sélection dans lequel les premières couches sont en SbSe et les deuxièmes couches sont en GeN. Dans cet exemple, chaque première couche de l'empilement 110 a une épaisseur sensiblement égale à 6 nm, et chaque deuxième couche a une épaisseur sensiblement égale à 1 nm.

Des courbes 128a et 128b correspondent, respectivement lors du dépôt (AS DEP) des couches de l'empilement 110 et lors de la chauffe des éléments de sélection à 400 °C, à un élément de sélection dans lequel les premières couches sont en SbSe et les deuxièmes couches sont en GeN. Dans cet exemple, chaque première couche de l'empilement 110 a une épaisseur sensiblement égale à 5 nm, et chaque deuxième couche a une épaisseur sensiblement égale à 1,5 nm.

Des courbes 130a et 130b correspondent, respectivement lors du dépôt (AS DEP) des couches de l'empilement 110 et lors de la chauffe des éléments de sélection à 400 °C, à un élément de sélection dans lequel les premières couches sont en SbSe et les deuxièmes couches sont en GeN. Dans cet exemple, chaque première couche de l'empilement 110 a une épaisseur sensiblement égale à 6 nm, et chaque deuxième couche a une épaisseur sensiblement égale à 2 nm.

Les courbes 124, 126, 128 et 130 ont été normalisées par rapport au nombre de liaisons Sb-Se d'une des courbes.

Lors du dépôt, les courbes 126a, 128a, 130a montrent chacune la présence, par un pic à la valeur de longueur d'onde correspondante, de liaisons SbSe et GeN. Ces liaisons sont les liaisons dans les couches correspondantes, en SbSe et GeN. Les courbes 126, 128, 130 montrent, de plus, un pic au niveau de la valeur de longueur d'onde correspondant à des liaisons Ge-Se. Les liaisons Ge-Se sont des liaisons formées aux niveaux des interfaces entre les couches GeN et SbSe. En effet, comme mentionné précédemment, pour des couches ayant une épaisseur inférieure à 20 nm, les éléments chimiques des deux couches forment, aux interfaces des couches, des liaisons, éventuellement des alliages, de la même manière que si les différents éléments chimiques étaient réunis dans un bloc massif.

La courbes 124a présente des pics au niveau des longueurs d'onde correspondant aux liaisons Sb-Se, Ge-Se et Ge-N, comme les courbes 126a, 128a, et 130a. Cependant, le pic correspondant aux liaisons Ge-N de la courbe 124a est sensiblement deux fois plus important que le pic correspondant aux liaisons Sb-Se.

Lorsque les éléments de sélection sont chauffés à 400°C, les courbes 124b, 126b, 128b, et 130b comprennent toujours des pics aux niveaux des liaisons Sb-Se, Ge-Se et Ge-N.

La présence des liaisons Ge-Se entraine la forte résistivité de l'empilement 110 dans le premier état. Cela permet d'assurer un premier état ayant un comportement similaire à celui d'un interrupteur ouvert. Ainsi, la présence de liaisons Ge-Se augmente la résistivité de l'empilement 110. Cependant, la présence de liaisons Ge-Se peut aussi entraîner une augmentation de la valeur de seuil (V2 en figure 2).

La présence d'antimoine (Sb permet de diminuer la tension de seuil par rapport à un élément comprenant un bloc massif de GeSe à la place de la région 108. Cette diminution de la tension de seuil est provoquée au moins partiellement par la formation de liaisons Se-Sb. Cependant, la présence d'antimoine (Sb) peut entraîner une déstabilisation du matériau de la deuxième portion. Ainsi, la présence d'antimoine (Sb) peut par exemple augmenter le risque de cristallisation d'une partie de l'empilement, en particulier les couches en SeSb, pendant les étapes de fabrication du dispositif comprenant l'élément de sélection.

La présence d'azote (N) permet de stabiliser le comportement de l'empilement et permet par exemple de retarder la cristallisation.

De manière plus générale, les différents composants peuvent être remplacés par des composants des mêmes groupes, tels qu'ils ont été décrits précédemment, de manière à obtenir des comportements similaires.

La figure 5 illustre des exemples de comparaisons de nombres de liaisons de la figure 4. En particulier, la figure 5 représente, d'une part, le ratio entre le nombre de liaisons Ge-Se par rapport au nombre de liaisons Sb-Se, et d'autre part, le nombre de liaisons Ge-Se par rapport au nombre de liaisons Ge-N, lors du dépôt et lorsque les éléments de sélection sont chauffés à 400°C. Les ratios sont obtenus pour les cas où les couches de l'empilement 110 ont une épaisseur sensiblement égale à celle décrite pour les courbes 130 (ML-A), pour les courbes 128 (ML-B) et pour les courbes 126 (ML-C) de la figure 3.

On observe que l'augmentation de l'épaisseur des couches entraine une diminution du nombre de liaisons Ge-Se, par rapport au nombre de liaisons Sb-Se et par rapport au nombre de liaisons Ge-N. En effet, lorsque l'épaisseur augmente, la proportion d'interfaces entre les couches, où se forment les liaisons Ge-Se, diminue par rapport au volume des couches, où sont situées les liaisons Sb-Se et Ge-N.

A partir d'une valeur d'épaisseur, par exemple au-dessus de 20 nm, la quantité de liaisons formées aux interfaces est trop faible pour que le comportement macroscopique de l'empilement 110 corresponde au comportement d'un bloc massif, comme cela est décrit en relation avec la figure 3.

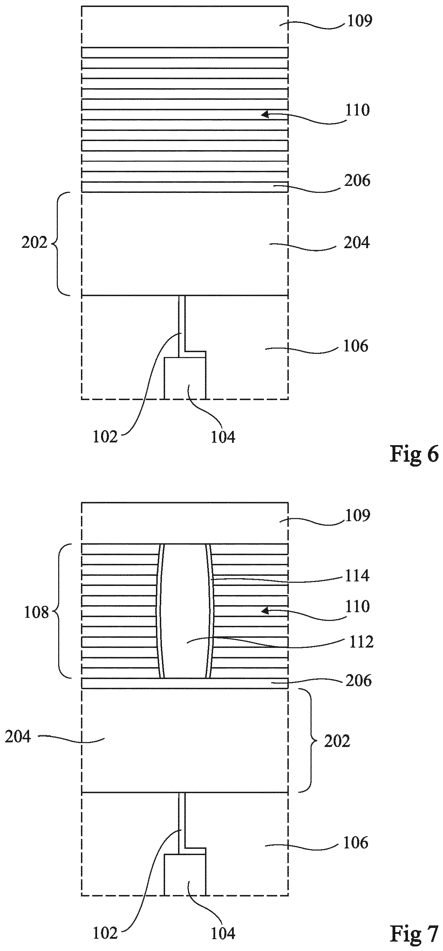

La figure 6 représente schématiquement et partiellement une structure obtenue à l'issue de la fabrication de la cellule mémoire de la figure 2. La figure 7 représente schématiquement et partiellement une structure obtenue après l'initialisation ou "firing" de la cellule mémoire de la figure 2.

La structure de la figure 6 est obtenue après des étapes comprenant :

- la formation de la couche isolante 106 ;

- la formation du via conducteur 104 ;

- la formation de l'électrode 102 ;

- la formation de l'élément de mémorisation 202, comprenant par exemple la formation de la couche ou de l'empilement de couches 204 à changement de phase ;

- la formation de la couche d'interface 206 ;

- la formation de l'empilement 110 sur la face supérieure de la couche isolante 106 et sur la face supérieure de la partie verticale de l'élément résistif 102. L'empilement 110 peut comprendre un nombre quelconque de couches, chaque couche ayant une épaisseur inférieure ou égale à 20 nm, par exemple inférieure ou égale à 5 nm ; et

- la formation de la couche conductrice 109, recouvrant la couche supérieure de l'empilement 110.

Les couches de l'empilement sont par exemple formées une par une par dépôt physique en phase vapeur (PVD - Physical Vapor Deposition).

La structure de la figure 7 est obtenue en faisant passer une impulsion de courant important entre les électrodes 102 et 109, ce qui entraine une augmentation de la température de la région 108. La température de l'électrode 102 devient alors suffisante pour que l'empilement 110 passe par une étape d'initialisation, aussi appelée "firing" au cours de laquelle la deuxième portion 112 est formée à partir des parties des couches de l'empilement chauffées. La peau 114 peut se former à cette étape.

Le procédé de fabrication de l'élément de sélection de la figure 1 est aisément déductible du procédé décrit ci-dessus.

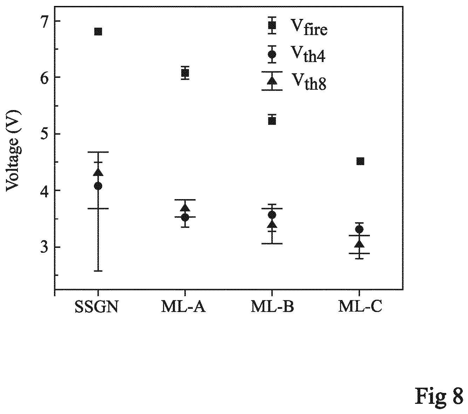

La figure 8 représente des dispersions de tensions (Voltage (V)) au cours de la vie de plusieurs modes de réalisation d'élément de sélection. Plus précisément, la figure 8 représente les dispersions de la tension de "firing" ($V_{fire}$), de la tension de seuil après 10 000 cycles ($V_{th4}$), et de la tension de seuil après 100 000 000 cycles ($V_{th8}$). Ces tensions sont représentées pour les cas où les couches de l'empilement 110 ont une épaisseur sensiblement égale à celle décrite pour les courbes 130 (ML-A), pour les courbes 128 (ML-B) et pour les courbes 126 (ML-C) de la figure 4, et pour le cas où l'empilement est remplacé par un bloc massif (SSGN). Par dispersion, on entend la gamme de valeurs pouvant être prises par la tension associée. Cette dispersion est par exemple obtenue en mesurant ladite tension pour un grand nombre d'éléments de sélection formés de la même manière. Par un cycle, on entend la mise sous tension de l'élément de sélection de manière à passer dans le deuxième état et le retour dans le premier état.

La tension de "firing" correspond à la tension utilisée pour former la deuxième portion dans l'empilement 110. La tension de seuil correspond à la tension à laquelle l'élément de sélection passe du premier état au deuxième état (V2 en figure 3), c'est-à-dire la tension minimale qu'il faut appliquer à l'élément de sélection pour qu'il se comporte similairement à un interrupteur fermé.

On observe que la dispersion de la tension de "firing" est faible, dans tous les cas. On observe, de plus, que la tension de "firing" est plus importante dans le cas où l'empilement est remplacé par une couche de matériau massif que dans les autres cas. De plus, plus l'épaisseur des couches de l'empilement est épaisse, plus la tension de "firing" est faible.

De plus, on observe que les dispersions des tensions de seuil $V_{th4}$ et $V_{th8}$ sont bien plus faibles dans les cas comprenant un empilement 110, par rapport au cas où l'empilement est remplacé par un bloc massif. En outre, plus l'épaisseur des couches de l'empilement est épaisse, plus la tension de seuil est faible.

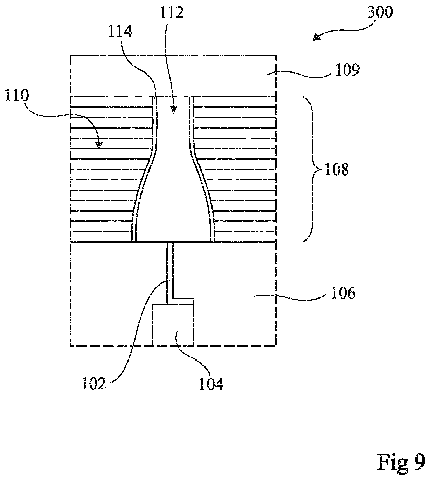

La figure 9 représente un mode de réalisation d'un élément de sélection 300. L'élément de sélection comprend, comme décrit en relation avec la figure 2, la couche isolante 106, le via conducteur 104, et la première électrode 102.

L'élément de sélection comprend, comme en figure 1, la région 108, c'est-à-dire les première et deuxième portions 110 et 112 ainsi que la peau 114. La région 108 repose, dans ce mode de réalisation sur la couche 106 et sur l'électrode 102, par exemple sur la face supérieure de la portion verticale de l'électrode 102. Plus précisément, l'électrode 102 est en contact avec la deuxième portion 112.

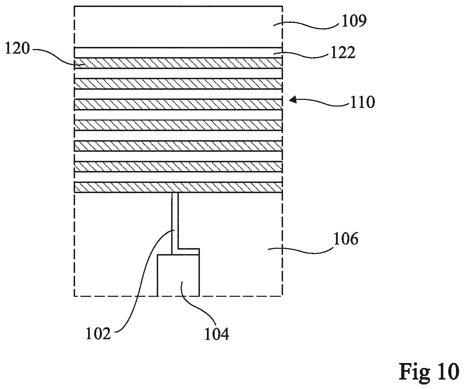

La figure 10 est une vue en coupe schématique et partielle d'un autre mode de réalisation d'un élément de sélection.

Plus précisément, la figure 10 représente une structure à un même stade de fabrication que la structure de la figure 6, lors de la fabrication d'un élément de sélection. La structure de la figure 10 comprend donc tous les éléments de la figure 6, à l'exception de l'élément de mémorisation 202 et de la couche d'interface 206. Dans cet exemple, l'électrode inférieure est l'électrode 102, ayant une forme de L. Cependant, l'électrode 102 pourrait être remplacée par l'électrode 52 de la figure 1.

L'empilement 110 du mode de réalisation de la figure 10 comprend des couches 120 et 122. Les couches 120 (couches hachurées) sont dopées et les couches 122 ne sont pas dopées. Le dopage des couches 120 est effectué de préférence couche par couche lors de la formation de l'empilement. Cela permet de contrôler précisément le dopage dans l'empilement.

Les couches 120 sont par exemple dopées avec un ou plusieurs dopants parmi l'azote, le carbone et le silicium.

Les couches 120 sont par exemple des couches en un germanium dopé avec de l'azote et les couches 122 sont par exemple un alliage à base d'antimoine et de sélénium. Dans cet exemple, les couches 120 sont dopées de manière sensiblement identique.

A titre de variante, l'empilement peut comprendre plusieurs ensembles de couches en des matériaux différents, chaque ensemble pouvant être ou non dopé. Par exemple, la partie haute de l'empilement 110 peut être dopée avec du carbone, de manière à réduire le risque d'inter diffusion entre le matériau de la couche 109 et le matériau de la couche supérieure de l'empilement 110, et la partie basse peut être dopée avec de l'azote de manière à augmenter la température de cristallisation.

Un tel dopage couche par couche a pour avantage de permettre l'interaction des dopants avec certains éléments de l'empilement mais pas avec tous, tout en conservant un empilement dont le comportement macroscopique est uniforme.

A titre de variante, l'empilement peut comprendre au moins un ensemble de couches dont le dopage est graduel. Par exemple, le dopage peut augmenter entre la couche dudit ensemble la plus proche de la couche inférieure de l'empilement et la couche dudit ensemble la plus proche de la couche supérieure de l'empilement. Par exemple, le dopage d'un ensemble de couches peut ne pas être linéaire. Ainsi, sur la hauteur de l'empilement, le dopage de cet ensemble de couches peut augmenter puis diminuer ou inversement.

Un tel dopage graduel a pour avantage de permettre, par exemple, la modulation de la résistivité du matériau à changement de phase sur sa hauteur.

De manière plus générale, un élément de sélection tel que celui décrit dans la présente description peut être utilisé dans un autre type de mémoire qu'une mémoire à changement de phase telle que décrite. De plus, l'élément de sélection peut être situé différemment par rapport à l'élément de mémorisation. Par exemple, un élément de sélection tel que celui décrit peut être situé à l'extrémité de chaque rangée ou colonne d'une matrice de cellules mémoire.

Un avantage des modes de réalisation décrits est que les types de dopage décrits en relation avec la figure 4 ne peuvent pas être obtenus par co-pulvérisation avec une technique de dépôt standard ou par implantation ionique.

Un avantage des modes de réalisation décrits est que le procédé de fabrication n'ajoute pas de variabilité entre différents éléments de mémorisation formés simultanément. Les éléments de mémorisation d'un même dispositif mémoire peuvent donc être dans un même état à l'initialisation, ce qui permet une augmentation du rendement de la mémoire.

Un autre avantage des modes de réalisation décrits est que les couches amorphes de la première portion 110 forment un isolant thermique. En effet, les éléments chimiques dans leur état amorphe conduisent moins bien la chaleur que dans leur état cristallin. Cela permet ainsi d'éviter la propagation de chaleur d'un élément à un élément voisin.

Un autre avantage est que la tension de "firing" est inférieure à celle d'un élément de sélection comprenant un bloc massif. La fabrication d'élément de sélection tels que décrit est donc moins coûteuse en énergie, en particulier dans des dispositifs comprenant plusieurs dizaines voire plusieurs milliers d'éléments de sélection.

Un autre avantage est que la tension de seuil à partir de laquelle l'élément de sélection passe du premier état au deuxième état a une dispersion plus faible que dans le cas d'un élément de sélection comprenant un bloc massif.

Un autre avantage est qu'il est possible de configurer, et d'optimiser, des caractéristiques électriques de l'élément de sélection, en utilisant les caractéristiques physiques de l'empilement de couches, par exemple le nombre de couches, les épaisseurs des couches, les matériaux des couches, leur dopage, etc.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'électrode inférieure soit, pour certains modes de réalisation, décrite comme ayant une coupe en L, il est bien entendu qu'il est possible pour l'électrode d'avoir une autre forme. Par exemple, l'électrode peut être une couche conductrice située en contact avec la couche inférieure de l'empilement 110.

Enfin, la mise en oeuvre pratique des modes de réalisation et variantes décrits est à la portée de la personne du métier à partir des indications fonctionnelles données ci-dessus.

**Revendications**

1. Elément de sélection (50, 100, 300) comprenant, dans une première portion (110), un empilement (110) de couches amorphes, l'épaisseur de chaque couche de l'empilement étant inférieure ou égale à 20 nm, au moins une des couches de l'empilement (110) comprenant un élément du groupe 16, **caractérisé en ce que** l'élément comprend une deuxième portion (112) traversant au moins certaines couches de l'empilement (110), en un alliage d'au moins une partie des composants des couches de l'empilement (110).

2. Elément selon la revendication 1, dans lequel au moins une des couches de l'empilement (110) comprend un élément parmi le sélénium, le tellure et le soufre.

3. Elément selon la revendication 1 ou 2, dans lequel l'empilement (110) comprend au moins un ensemble de premières couches et un ensemble de deuxièmes couches, les premières et deuxièmes couches étant en des matériaux différents.

4. Elément selon la revendication 3, dans lequel les premières couches sont en un alliage comprenant un élément du groupe 15 et un élément du groupe 16, et dans lequel les deuxièmes couches sont en :

   - un élément du groupe 14 seul ou dopé, par exemple dopé avec de l'azote, de l'oxygène ou du carbone ; ou
   - un alliage comprenant un élément du groupe 14 et un élément du groupe 16.

5. Elément selon la revendication 3 ou 4, dans lequel l'empilement (110) comprend une alternance de premières et de deuxièmes couches.

6. Elément selon l'une quelconque des revendications 3 à 5, dans lequel les premières couches sont en un alliage à base de germanium dopé avec de l'azote, et les deuxièmes couches sont en un alliage d'antimoine et de sélénium.

7. Elément selon l'une quelconque des revendications 1 à 6, dans lequel le matériau de chaque couche de l'empilement (110) a des proportions stoechiométriques.

8. Elément selon l'une quelconque des revendications 1 à 7, comprenant une électrode (52, 102) en contact avec la deuxième portion (112).

9. Elément selon l'une quelconque des revendications 1 à 8, dans lequel des couches (120) d'un ensemble de couches de l'empilement (110) sont dopées.

10. Elément selon la revendication 9, dans lequel les couches de l'ensemble de couches (120) sont dopées avec un ou plusieurs dopants parmi l'azote, le carbone et le silicium.

11. Dispositif mémoire (200) comprenant un élément de mémorisation (202) disposé électriquement en série avec un élément de sélection défini selon l'une quelconque des revendications 1 à 10.

12. Procédé de fabrication d'un élément de sélection (100) comprenant la formation d'un empilement (110) de couches amorphes, l'épaisseur de chaque couche étant inférieure ou égale à 20 nm, au moins une des couches de l'empilement (110) comprenant un élément du groupe 16, **caractérisé en ce que** l'élément comprend une deuxième portion (112) traversant au moins certaines couches de l'empilement (110), en un alliage d'au moins une partie des composants des couches de l'empilement (110) .

13. Procédé selon la revendication 12, comprenant une étape au cours de laquelle une impulsion de courant est envoyée à travers l'empilement (110) de couches, de manière à former une portion comprenant un alliage d'au moins une partie des composants des couches de l'empilement (110).

**14.** Procédé selon la revendication 12 ou 13, comprenant une étape de fabrication d'une électrode inférieure (52, 102) et la fabrication d'une électrode supérieure (109).

**Patentansprüche**

**1.** Ein Auswahlelement (50, 100, 300), das in einem ersten Bereich (110) einen Stapel (110) aus amorphen Schichten aufweist, wobei die Dicke jeder Schicht des Stapels kleiner oder gleich 20 nm ist, wobei wenigstens eine der Schichten des Stapels (110) ein Gruppe-16-Element aufweist, **dadurch gekennzeichnet, dass** das Element einen zweiten Bereich (112) aufweist, der wenigstens bestimmte Schichten des Stapels (110) kreuzt und aus einer Legierung aus wenigstens einem Teil der Komponenten der Schichten des Stapels (110) hergestellt ist.

**2.** Element nach Anspruch 1, wobei wenigstens eine der Schichten des Stapels (110) ein Element unter Selen, Tellur und Schwefel aufweist.

**3.** Element nach einem der Ansprüche 1 oder 2, wobei der Stapel (110) wenigstens eine Anordnung von ersten Schichten und eine Anordnung von zweiten Schichten aufweist, wobei die ersten und zweiten Schichten aus unterschiedlichen Materialien hergestellt sind.

**4.** Element nach Anspruch 3, wobei die ersten Schichten aus einer Legierung bestehen, die ein Gruppe-15-Element und ein Gruppe-16-Element aufweist, und wobei die zweiten Schichten aus Folgendem hergestellt sind:

- einem Gruppe-14 Element, allein oder dotiert, zum Beispiel Stickstoff-, Sauerstoff- oder Kohlenstoff-dotiert; oder
- einer Legierung aus einem Gruppe-14-Element und einem Gruppe-16-Element.

**5.** Element nach Anspruch 3 oder 4, wobei der Stapel (110) eine Wechselfolge von ersten und zweiten Schichten aufweist.

**6.** Element nach einem der Ansprüche 3 bis 5, wobei die ersten Schichten aus einer stickstoffdotierten Germaniumlegierung und die zweiten Schichten aus einer Legierung aus Antimon und Selen hergestellt sind.

**7.** Element nach einem der Ansprüche 1 bis 6, wobei das Material jeder Schicht des Stapels (110) stöchiometrische Verhältnisse aufweist.

**8.** Element nach einem der Ansprüche 1 bis 7, das eine Elektrode (52, 102) in Kontakt mit dem zweiten Bereich (112) aufweist.

**9.** Element nach einem der Ansprüche 1 bis 8, wobei Schichten (120) einer Anordnung von Schichten des Stapels (110) dotiert sind.

**10.** Element nach Anspruch 9, wobei die Schichten der Schichtanordnung (120) mit einem oder mehreren Dotierstoffen aus Stickstoff, Kohlenstoff und Silizium dotiert sind.

**11.** Speichervorrichtung (200) mit einem Speicherelement (202), das elektrisch in Reihe mit einem Auswahlelement angeordnet ist, das nach einem der Ansprüche 1 bis 10 definiert ist.

**12.** Verfahren zum Herstellen eines Auswahlelements (100), aufweisend Ausbilden eines Stapels (110) aus amorphen Schichten, wobei die Dicke jeder Schicht kleiner oder gleich 20 nm ist, wobei wenigstens eine der Schichten des Stapels (110) ein Gruppe-16-Element aufweist, **dadurch gekennzeichnet, dass** das Element einen zweiten Bereich (112) aufweist, der wenigstens bestimmte Schichten des Stapels (110) kreuzt und aus einer Legierung von wenigstens einem Teil der Komponenten der Schichten des Stapels (110) hergestellt ist.

**13.** Verfahren nach Anspruch 12, aufweisend einen Schritt, bei dem ein Stromimpuls durch den Stapel (110) von Schichten geschickt wird, um einen Bereich auszubilden, der eine Legierung von wenigstens einem Teil der Komponenten der Schichten des Stapels (110) aufweist.

**14.** Verfahren nach Anspruch 12 oder 13, aufweisend einen Schritt des Herstellens einer unteren Elektrode (52, 102) und des Herstellens einer oberen Elektrode (109).

**Claims**

1. Selection element (50, 100, 300) comprising, in a first portion (110), a stack (110) of amorphous layers, the thickness of each layer in the stack being smaller than or equal to 20 nm, at least one of the layers in the stack (110) comprising a group-16 element, **characterized in that** the element comprises a second portion (112) crossing at least certain layers of the stack (110), made of an alloy of at least part of the components of the layers of the stack (110).

2. Element according to claim 1, wherein at least one of the layers in the stack (110) comprises an element among selenium, tellurium, and sulfur.

3. Element according to any of claims 1 or 2, wherein the stack (110) comprises at least one assembly of first layers and one assembly of second layers, the first and second layers being made of different materials.

4. Element according to claim 3, wherein the first layers are made of an alloy comprising a group-15 element and a group-16 element, and wherein the second layers are made of:

   - a group-14 element, alone or doped, for example, nitrogen-, oxygen-, or carbon-doped; or
   - an alloy comprising a group-14 element and a group-16 element.

5. Element according to claim 3 or 4, wherein the stack (110) comprises an alternation of first and of second layers.

6. Element according to any of claims 3 to 5, wherein the first layers are made of a nitrogen-doped germanium alloy, and the second layers are made of an alloy of antimony and of selenium.

7. Element according to any of claims 1 to 6, wherein the material of each layer of the stack (110) has stoichiometric proportions.

8. Element according to any of claims 1 to 7, comprising an electrode (52, 102) in contact with the second portion (112) .

9. Element according to any of claims 1 to 8, wherein layers (120) of an assembly of layers of the stack (110) are doped.

10. Element according to claim 9, wherein the layers of the layer assembly (120) are doped with one or a plurality of dopants among nitrogen, carbon, and silicon.

11. Memory device (200) comprising a storage element (202) arranged electrically in series with a selection element defined according to any of claims 1 to 10.

12. Method of manufacturing a selection element (100) comprising forming a stack (110) of amorphous layers, the thickness of each layer being smaller than or equal to 20 nm, at least one of the layers in the stack (110) comprising a group-16 element, **characterized in that** the element comprises a second portion (112) crossing at least certain layers of the stack (110), made of an alloy of at least part of the components of the layers of the stack (110).

13. Method according to claim 12, comprising a step during which a current pulse is sent through the stack (110) of layers, in order to form a portion comprising an alloy of at least part of the components of the layers of the stack (110) .

14. Method according to claim 12 or 13, comprising a step of manufacturing of a lower electrode (52, 102) and the manufacturing of an upper electrode (109).

Fig 1

Fig 2

Fig 3

Fig 4

Fig 5

Fig 6

Fig 7

Fig 8

Fig 9

Fig 10

**EP 3 863 075 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2019115393 A